# EUROPEAN PATENT SPECIFICATION

(11) **EP 3 888 846 B1**
(45) Date of publication and mention of the grant of the patent: **29.01.2025**
(21) Application number: 21166606.0
(22) Date of filing: 01.04.2021
(51) Int. Cl.: B24B 9/06, H01L 21/02

(54) **SEMICONDUCTOR SUBSTRATE AND METHOD FOR MANUFACTURING THE SAME**
HALBLEITERSUBSTRAT UND VERFAHREN ZUR HERSTELLUNG DAVON
SUBSTRAT SEMI-CONDUCTEUR ET SON PROCÉDÉ DE FABRICATION

(30) Priority: 01.04.2020 JP 2020065514
(43) Date of publication of application: 06.10.2021
(73) Proprietor: Novel Crystal Technology, Inc., Sayama-shi, Saitama 350-1328 (JP)
(72) Inventor: WATANABE, Shinya, Saitama, 350-1328 (JP); YOKOO, Masanori, Saitama, 350-1328 (JP)
(74) Representative: Betten & Resch

(56) References cited:
- EP-A1- 2 924 150
- JP-A- 2016 013 930
- US-B1- 6 174 222

## Description

The present invention relates to a semiconductor substrate and a method for manufacturing the same.

### Background Art

Conventionally, glass plates having a chamfered outer periphery portion are known (see Patent Literature 1). The glass plate described in Patent Literature 1 is used as a support plate for supporting a workpiece substrate in fan-out wafer-level packaging.

According to Patent Literature 1, since a notch-shaped or orientation flat-shaped alignment portion of the glass plate is chamfered, damage on the glass plate originating from a positioning member such as positioning pin can be effectively avoided when brought into contact with the positioning member.

### Citation List

### Patent Literature

### Patent Literature 1: WO 2016/088868

### Summary of Invention

However, damageability of plate-like objects including glass plates and semiconductor substrates is different depending on characteristics of material such as cleavage planes in a crystal, and the shape of the chamfered portion which can effectively suppress damage is thus also different depending on the material of the plate-shaped object. Therefore, even if the shape of the chamfered portion of the glass plate described in Patent Literature 1 is applied to a plate-shaped object formed of another material, it is not necessarily possible to effectively suppress damages.

It is an object of the invention to provide a semiconductor substrate which includes a gallium oxide-based semiconductor single crystal and is configured to effectively suppress occurrence of damage, as well as a method for manufacturing the semiconductor substrate.

A gallium oxide-based single crystal substrate is e.g. known from document JP2016 013930 A. The known semiconductor substrate comprises a chamfered portion at its outer periphery.

According to the invention, a semiconductor substrate and a method for manufacturing a semiconductor substrate are defined in the independent claims. Embodiments of the invention are subject to the dependent claims.

### Brief Description of Drawings

FIG. 1 is a perspective view showing a semiconductor substrate in an embodiment of the present invention.
FIG. 2A is a partially enlarged vertical cross-sectional view showing the semiconductor substrate in the embodiment of the invention.
FIG. 2B is a partially enlarged vertical cross-sectional view showing the semiconductor substrate in the embodiment of the invention.
FIG. 3 is a schematic diagram illustrating a crystal structure of β-Ga₂O₃ that is a typical example of a gallium oxide-based semiconductor constituting the semiconductor substrate in the embodiment of the invention.
FIG. 4 is a top view showing the semiconductor substrate in the embodiment of the invention that has an orientation flat.
FIG. 5 is a flowchart showing an example of a process of manufacturing the semiconductor substrate in the embodiment of the invention.
FIG. 6A is a schematic diagram illustrating a state of a crystalline substance as a material of the semiconductor substrate in the process of manufacturing the semiconductor substrate.
FIG. 6B is a schematic diagram illustrating a state of a crystalline substance as a material of the semiconductor substrate in the process of manufacturing the semiconductor substrate.
FIG. 6C is a schematic diagram illustrating a state of a crystalline substance as a material of the semiconductor substrate in the process of manufacturing the semiconductor substrate.
FIG. 7A is a perspective view showing a grinding wheel that can be used to chamfer the semiconductor substrate in the embodiment of the invention.
FIG. 7B is a partially enlarged vertical cross-sectional view showing the grinding wheel.
FIG. 8A is a vertical cross-sectional view showing a chamfered portion and therearound of a sample A before polishing principal surfaces.
FIG. 8B is a vertical cross-sectional view showing the chamfered portion and therearound of the sample A after polishing the principal surfaces.
FIG. 9A is a vertical cross-sectional view showing the chamfered portion and therearound of a sample B before polishing the principal surfaces.
FIG. 9B is a vertical cross-sectional view showing the chamfered portion and therearound of the sample B after polishing the principal surfaces.
FIG. 10A is a vertical cross-sectional view showing the chamfered portion and therearound of a sample C after polishing the principal surfaces.
FIG. 10B is a vertical cross-sectional view showing the chamfered portion and therearound of a sample D after polishing the principal surfaces.
FIG. 11A is a vertical cross-sectional view showing the chamfered portion and therearound of a sample E after polishing the principal surfaces.
FIG. 11B is a vertical cross-sectional view showing the chamfered portion and therearound of a sample F after polishing the principal surfaces.
FIG. 12A is a vertical cross-sectional view showing the chamfered portion and therearound of a sample G after polishing the principal surfaces.
FIG. 12B is a vertical cross-sectional view showing the chamfered portion and therearound of a sample H after polishing the principal surfaces.
FIG. 13A is a vertical cross-sectional view showing the chamfered portion and therearound of a sample I after polishing the principal surfaces.
FIG. 13B is a vertical cross-sectional view showing the chamfered portion and therearound of a sample J after polishing the principal surfaces.

### Description of Embodiments

### (Embodiment)

### (Structure of a semiconductor substrate)

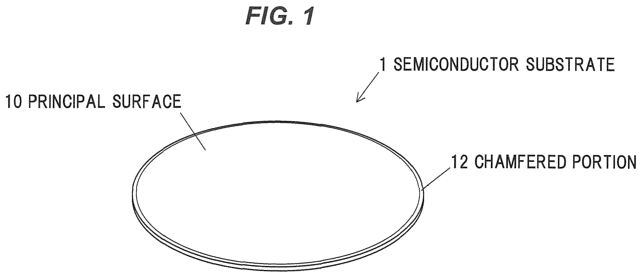

FIG. 1 is a perspective view showing a semiconductor substrate 1 in the embodiment of the invention. The semiconductor substrate 1 is a semiconductor substrate that is formed of a gallium oxide-based semiconductor single crystal and has a chamfered (beveled) portion 12 at an outer periphery portion.

Gallium oxide-based semiconductor here means β-Ga₂O₃, or means β-Ga₂O₃ containing a substitutional impurity such as Al, In, or a dopant such a Sn, Si.

The chamfered portion 12 is provided to prevent damage on the semiconductor substrate 1 during polishing or conveyance in the manufacturing process, or during handling such as conveyance and alignment, etc. If the chamfered portion 12 is not provided and edges of the semiconductor substrate 1 (boundaries between principal surfaces 10, 11 and a side surface) are square edges, e.g., the edges are damaged during polishing of the principal surfaces 10, 11, and also, broken pieces scratch or contaminate the principal surfaces 10, 11.

The plane orientations of the principal surfaces 10, 11 of the semiconductor substrate 1 are not specifically limited, but damage due to cleavage is particularly likely to occur when the principal surfaces are (001) planes or (100) planes. Therefore, an effect of suppressing damage in the invention is thus particularly important.

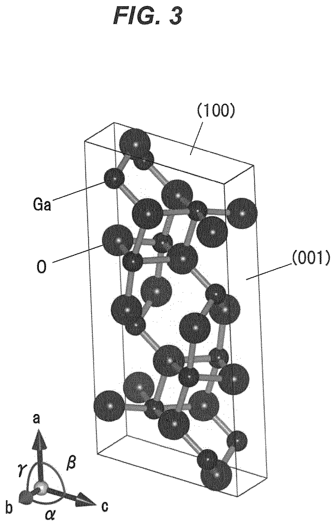

FIG. 3 is a schematic diagram illustrating a crystal structure of β-Ga₂O₃ that is a typical example of a gallium oxide-based semiconductor constituting the semiconductor substrate 1. The (001) plane and the (100) plane are cleavage planes of the gallium oxide-based semiconductor and cleavage is likely to occur along these planes. In more particular, it is most likely to cleave along the (100) plane and it is next most likely to cleave along the (001) plane.

In addition, when polishing the semiconductor substrate 1, polishability is different since a surface having a plane orientation close to the cleavage plane is relatively soft and a surface having a plane orientation far from the cleavage plane is relatively hard. The gallium oxide-based semiconductor is monoclinic. Therefore, when the semiconductor substrate 1 is a substrate including a curved line in an outer contour of its planar shape, such as a circular substrate, the plane orientation of the polished portion continuously changes during chamfering of the outer periphery portion and it is highly difficult to process.

When the principal surfaces 10, 11 of the semiconductor substrate 1 are the (001) planes, cleavage is likely to occur along the (100) plane intersecting the principal surfaces 10, 11 at 103.7°, and cleavage can also occur along the (001) plane parallel to the principal surfaces 10, 11. Cleavage along the (001) plane hardly occurs during polishing of the principal surfaces 10, 11 but can occur during processing of the substrate end face, such as during chamfering.

When the principal surfaces 10, 11 of the semiconductor substrate 1 are the (100) planes, cleavage is likely to occur along the (100) plane parallel to the principal surfaces 10, 11 and cleavage can occur along the (001) plane intersecting the principal surfaces 10, 11 at 103.7°. Cleavage along the (100) plane occurs during processing of the substrate end face but is also likely to occur during polishing of the principal surfaces 10, 11.

When the principal surfaces 10, 11 of the semiconductor substrate 1 are (-201) planes, cleavage can occur along the (100) plane intersecting the principal surfaces 10, 11 at 53.8° but hardly occurs along the (001) plane intersecting the principal surfaces at 49.9°.

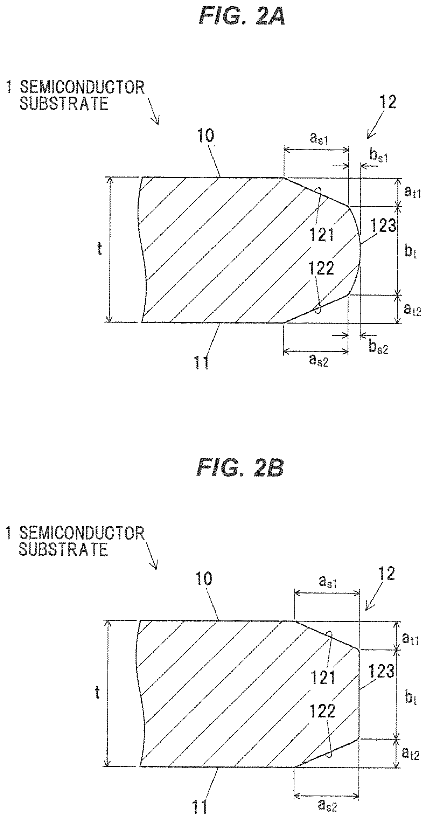

FIGS. 2A and 2B are partially enlarged vertical cross-sectional views showing the semiconductor substrate 1. FIGS. 2A and 2B show vertical cross-sectional shapes around the chamfered portion 12 of the semiconductor substrate 1.

The chamfered portion 12 of the semiconductor substrate 1 has an inclined surface 121 on the principal surface 10 side of the semiconductor substrate 1, an inclined surface 122 on the principal surface 11 side opposite to the principal surface 10, and an end face 123 located between the inclined surface 121 and the inclined surface 122 at a leading end of the chamfered portion 12.

The inclined surface 121 is an annularly continuous surface that is located on the outer side of the principal surface 10 and is linear at an edge in the vertical cross section of the semiconductor substrate 1. The inclined surface 122 is an annularly continuous surface that is located on the outer side of the principal surface 11 and is linear at an edge in the vertical cross section of the semiconductor substrate 1. The end face 123 is an annularly continuous surface that can be regarded as a side surface of the semiconductor substrate 1.

When the semiconductor substrate 1 is, e.g., a circular substrate as shown in FIG. 1, the inclined surface 121, the inclined surface 122 and the end face 123 are respectively annularly continuous.

A width bt of the end face 123 in a thickness direction of the semiconductor substrate 1 is within the range of not less than 50% and not more than 97% of a thickness t of the semiconductor substrate 1. When the width bt is not less than 50% of the thickness t, it is possible to effectively suppress damage on the leading end of the chamfered portion 12 including the end face 123, particularly, damage due to cleavage, during a step of forming the chamfered portion 12 (Step S5 in a manufacturing process described later), during steps thereafter (Steps S6, S7), and even during handling such as conveyance or alignment of the semiconductor substrate 1. Meanwhile, when the width bt is not more than 97% of the thickness t, it is possible to effectively suppress the above-mentioned damage on the edge of the semiconductor substrate 1, particularly scratches caused by broken pieces during polishing of the principal surfaces 10, 11.

In case that the width bt of the end face 123 in the thickness direction of the semiconductor substrate 1 is within the range of not less than 50% and not more than 97% of the thickness t of the semiconductor substrate 1, it is possible to effectively suppress damage on the semiconductor substrate 1 such as the above-described damage on the leading end of the chamfered portion 12 and scratches caused by broken pieces during polishing even when the plane orientations of the principal surfaces 10, 11 are (001) or (100). In other words, regardless of the plane orientations of the principal surfaces 10, 11, it is possible to effectively suppress damage on the semiconductor substrate 1.

In addition, to suppress damage on the semiconductor substrate 1 more effectively, the width bₜ is preferably within the range of not less than 55% and not more than 90% of the thickness t, more preferably, within the range of not less than 60% and not more than 86%. A distance bₛ₁ from a boundary between the end face 123 and the inclined surface 121 to the outermost point of the end face 123 in an in-plane direction of the semiconductor substrate 1 (a direction parallel to the principal surfaces 10, 11) is typically equal to, but may be different from, a distance bₛ₂ from a boundary between the end face 123 and the inclined surface 122 to the outermost point of the end face 123 in the in-plane direction of the semiconductor substrate 1.

Widths aₛ₁ and aₛ₂ of the inclined surface 121 and the inclined surface 121 in the in-plane direction of the semiconductor substrate 1 (a direction parallel to the principal surfaces 10, 11) are preferably within the range of not less than 0.025 mm and not more than 0.9 mm. When the widths aₛ₁, aₛ₂ are not less than 0.025 mm, it is possible to effectively suppress the above-described damage on the edge of the semiconductor substrate 1, particularly scratches caused by broken pieces during polishing of the principal surfaces 10, 11. Meanwhile, when the width aₛ₁, aₛ₂ are not more than 0.9 mm, a chamfering amount is reduced, hence, an effect of improving chamfering efficiency and an effect of reducing the manufacturing cost of the semiconductor substrate 1 by suppressing wear of the grinding wheel used for chamfering, etc., are obtained.

To obtain such effects more reliably, the widths aₛ₁, aₛ₂ are preferably within the range of not less than 0.05 mm and not more than 0.45 mm, more preferably, within the range of not less than 100 µm and not more than 200 µm. The width aₛ₁ and a width aₜ₁ of the inclined surface 121 (the width aₜ₁ along the thickness direction of the semiconductor substrate 1) are typically respectively equal to, but may be different from, the width aₛ₂ and a width aₜ₂ of the inclined surface 122 (the width aₜ₂ along the thickness direction of the semiconductor substrate 1.

The end face 123 may be curved along the thickness direction of the semiconductor substrate 1 so as to bulge outward as shown in FIG. 2A, or may be flat along the thickness direction of the semiconductor substrate 1 as shown in FIG. 2B.

The end face 123 when curved along the thickness direction of the semiconductor substrate 1 as shown in FIG. 2A has a smaller contact area with the grinding wheel during processing and stress is less likely to concentrate, hence, damage on the leading end of the chamfered portion 12 including the end face 123 can be suppressed more effectively. The end face 123 may be flat along the thickness direction of the semiconductor substrate 1 when damage during processing is suppressed sufficiently. In addition, when the leading end of the chamfered portion 12 is too sharp, cleavage is likely to occur at the leading end. Therefore, a curvature radius of the end face 123 in the vertical cross section of the semiconductor substrate 1 is preferably not less than 340 µm.

The thickness of the semiconductor substrate 1 is preferably less than 1 mm, more preferably, less than 0.7 mm. It is because the semiconductor substrate 1 formed of a gallium oxide-based semiconductor has a lower thermal conductivity than substrates formed of other semiconductors and is thus required to be thin to ensure heat dissipation of device. In addition, to suppress cracks during handling such as conveyance or work at the time of using the semiconductor substrate 1 (epitaxial growth, device manufacturing, etc.,), the thickness of the semiconductor substrate 1 is preferably not less than 0.1 mm, more preferably, not less than 0.3 mm. Even when the chamfered portion 12 has a shape capable of suppressing damage on the semiconductor substrate 1 as described above, the semiconductor substrate 1 when too thin may crack due to stress generated during conveyance or handling.

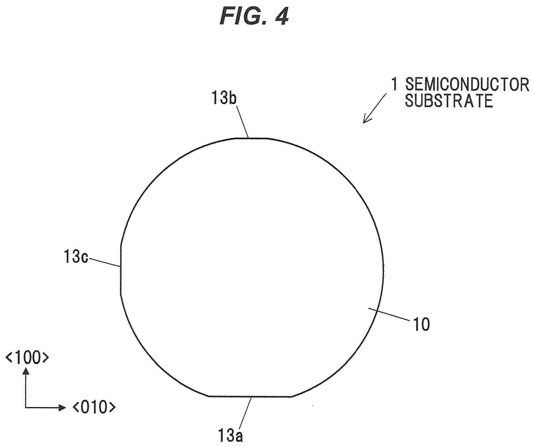

FIG. 4 is a top view showing the semiconductor substrate 1 that has an orientation flat. The semiconductor substrate 1 may have an orientation flat for alignment, as shown in FIG. 4. When the orientation flat is provided, an orientation flat portion is also chamfered in the same manner as for the outer periphery portion not having the orientation flat to form a chamfered portion having the same vertical cross-sectional shape.

In the example shown in FIG. 4, the semiconductor substrate 1 has (001) planes on the principal surfaces 10, 11 and has an orientation flat 13a along a <010> direction that is a direction of a line of intersection between the principal surface 11 and a (100) plane as a cleavage plane. Since a portion with a small (100) plane area in the vicinity of the outer periphery portion of the substrate is removed by providing the orientation flat 13a along the <010> direction, it is possible to suppress cleavage along the (100) plane on the orientation flat 13a side of the semiconductor substrate 1.

Additionally, an orientation flat 13b along the <010> direction may be provided on the semiconductor substrate 1 on the opposite side to the orientation flat 13a. It is thereby possible to suppress cleavage along the (100) plane also on the orientation flat 13b side of the semiconductor substrate 1.

Meanwhile, since it is not possible to distinguish front and back of the semiconductor substrate 1 only by the orientation flat 13a or only by the orientation flats 13a, 13b, an orientation flat 13c for distinguishing front and back may be provided along a <100> direction, etc., that is orthogonal to the <010> direction.

The planar shape of the semiconductor substrate 1 is typically a circular shape or a circle with an orientation flat, but may be another shape such as a polygonal shape. Also in such a case, the outer periphery portion of the substrate is chamfered in the same manner as when having a circular shape to form a chamfered portion having the same vertical cross-sectional shape.

### (Process for manufacturing Semiconductor substrate)

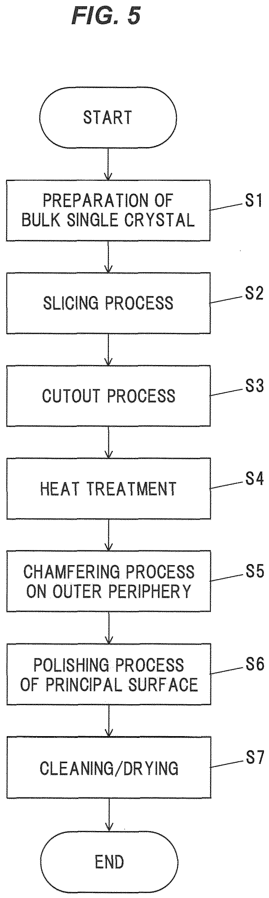

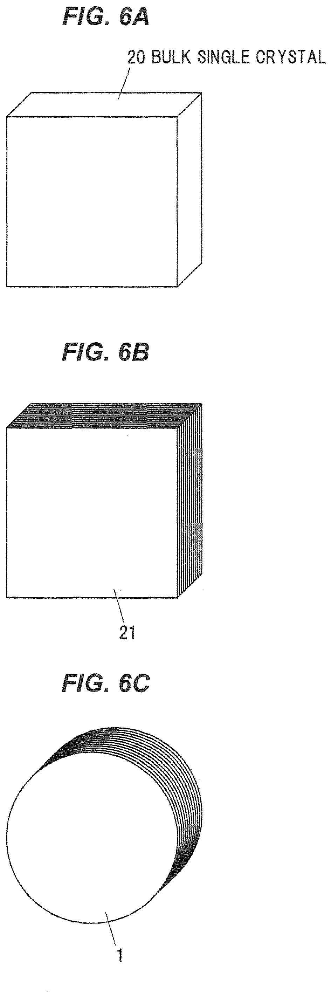

FIG. 5 is a flowchart showing an example of a process of manufacturing the semiconductor substrate 1. FIGS. 6A to 6C are schematic diagrams illustrating states of a crystalline substance as a material of the semiconductor substrate 1 in the process of manufacturing the semiconductor substrate 1. Next, a process flow of manufacturing the semiconductor substrate 1 will be described along with the flowchart in FIG. 5.

Firstly, a bulk single crystal 20 as shown in FIG. 6A is prepared (Step S1). The bulk single crystal 20 is a gallium oxide-based semiconductor single crystal block that is cut out of a single crystal ingot grown by a single crystal growth method such as the EFG (Edge Defined Film Fed Growth) method, the VB (Vertical Bridgman) method, the FZ (Floating Zone) method or the CZ (Czochralski) method.

The square plate-shaped bulk single crystal 20 shown in FIG. 6A is an example of the bulk single crystal 20 that is cut out of a plate-shaped ingot grown by the EFG method. The bulk single crystal 20 cut out of a circular column-shaped ingot grown by the VB method, the FZ method or the CZ method, etc., has a circular plate shape.

Next, plural single crystal plates 21 shown in FIG. 6B are obtained by slicing the bulk single crystal 20 (Step S2). The bulk single crystal 20 is sliced using, e.g., a multi-wire saw. It is possible to use a fixed abrasive wire saw or a free abrasive wire saw, and a slicing speed is preferably about 0.125 to 0.3 mm/min.

Next, a cutout step is performed on the plural single crystal plates 21 to cut out the plural semiconductor substrates 1 shown in FIG. 6C (Step S3). The cutout step of the single crystal plates 21 is performed by, e.g., wire electrical discharge machining, grinding the outer periphery, ultrasonic machining, or coring using a core drill, etc. In this regard, the order of the slicing step in Step S2 and the cutout step in Step S3 may be reversed.

When orientation flats are formed on the semiconductor substrates 1, for example, the semiconductor substrate 1 having a shape including an orientation flat may be cut out by wire electrical discharge machining, grinding the outer periphery, or ultrasonic machining, etc., in the cutout step in Step S3, or the semiconductor substrate 1 cut out into a circular shape by the cutout step may be partially cut off by a slicing machine.

Next, the semiconductor substrates 1 are heat-treated to relieve processing strain and thereby reduce the amount of warpage (Step S4). For example, heat treatment during heating up is performed in an oxygen atmosphere, and heat treatment while holding temperature after heating up is performed in an inert atmosphere such as nitrogen atmosphere, argon atmosphere or helium atmosphere. The holding temperature is preferably 1400 to 1600°C.

Next, the outer periphery portion of each semiconductor substrate 1 is chamfered to form the chamfered portion 12 (Step S5). Chamfering is performed using, e.g., an outer periphery machining device provided with a circular plate-shaped grinding wheel. The size of the semiconductor substrate 1 may be adjusted by grinding the outer periphery before chamfering.

When forming the chamfered portion 12, a step of forming the inclined surfaces 121, 122 and a step of forming the end face 123 are preferably separately performed in such a manner that the end face 123 is formed after forming the inclined surfaces 121, 122. As a result, it is possible to suppress damage due to cleavage during the step of forming the end face 123.

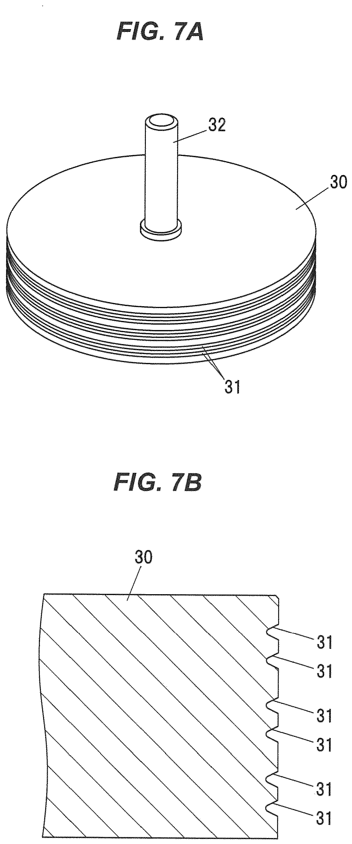

FIG. 7A is a perspective view showing a grinding wheel 30 that can be used to chamfer the semiconductor substrate 1. The circular plate-shaped grinding wheel 30 has plural grooves 31 along the side surface thereof, and a shaft 32 is attached thereto so as to be located on the center axis thereof.

FIG. 7B is a partially enlarged vertical cross-sectional view showing the grinding wheel 30. FIG. 7B shows a vertical cross-sectional shape of the side surface of the grinding wheel 30 on which the grooves 31 are provided. When chamfering the semiconductor substrate 1 using the grinding wheel 30, the semiconductor substrate 1 is brought close to the grinding wheel 30 from the side while rotating the grinding wheel 30 about the rotational axis of the shaft 32, so that the outer periphery portion of the semiconductor substrate 1 proceeds into the grooves 31 and is ground by inner surfaces of the grooves 31.

When forming the inclined surfaces 121, 122, it is preferable to use a relatively hard grinding wheel as the grinding wheel 30 to suppress changes in the shape of the grooves 31 due to wear of the grinding wheel 30. On the other hand, when forming the end face 123, a grinding wheel softer than the grinding wheel used to form the inclined surfaces 121, 122 is preferably used as the grinding wheel 30 since damage due to cleave along the (100) plane or the (001) plane is likely to occur when a hard grinding wheel is used. In this case, a metal bonded grinding wheel (e.g., grit #600) can be used to form the inclined surfaces 121, 122, and a resin bonded grinding wheel (e.g., grit #1000) can be used to form the end face 123.

When the semiconductor substrate 1 has a circular shape, the entire region of the outer periphery portion is polished by the grinding wheel 30 while rotating the semiconductor substrate 1. When an orientation flat is formed on the semiconductor substrate 1, the orientation flat portion is chamfered by laterally sliding the semiconductor substrate 1 relative to the grinding wheel 30 without rotating the semiconductor substrate 1.

Next, the principal surfaces 10, 11 of the semiconductor substrate 1 are polished (Step S6). The polishing step of the principal surfaces 10, 11 is performed by, e.g., lapping using a single-sided polishing machine or a double-sided polishing machine, and then polishing. Dry etching, chemical etching or thermal etching, etc., may be performed in addition to mechanical polishing such as lapping and polishing. An amount of polishing each of the principal surfaces 10, 11 in this polishing step is about 10 to 300 µm in the thickness direction of the semiconductor substrate 1.

In a specific example of the polishing step in Step S6, firstly, the principal surfaces 10, 11 of the semiconductor substrate 1 are ground or lapped and polished using a diamond grinding wheel or using a polishing platen and a diamond-based slurry. The grit of the diamond grinding wheel is preferably about #800 to 1000 (specified by JIS B 4131). The polishing platen is preferably formed of a metal-based, glass-based, or resin-based material. The grain size of diamond-based abrasive grains contained in the diamond-based slurry is preferably about 0.5 to 8 µm. Next, the principal surfaces 10, 11 of the semiconductor substrate 1 are polished using a polishing cloth and a CMP (Chemical Mechanical Polishing) slurry until atomic level flatness (e.g., an average roughness Ra of 0.05 to 0.28 nm) is obtained. The polishing cloth is preferably formed of nylon, cotton fibers or urethane, etc. It is preferable to use colloidal silica as abrasive grains in the slurry.

After that, the semiconductor substrate 1 is cleaned and dried (Step S7). In particular, e.g., ultrasonic cleaning or scrub cleaning using an acid-based or alkaline-based detergent, 5 minutes of running water cleaning, 5 minutes of sulfuric acid-water cleaning, and 15 minutes of running water cleaning are subsequently performed. Next, the drying is performed by a method such as spin drying, vacuum drying, Marangoni drying, hot air drying or lift frying, etc.

The semiconductor substrate 1 after the polishing step in Step S6 satisfies the condition that the width bt of the end face 123 in the thickness direction of the semiconductor substrate 1 is within the range of not less than 50% and not more than 97% of the thickness t of the semiconductor substrate 1. Thus, damage on the semiconductor substrate 1 in Steps S5 to S7 can be suppressed.

### Effects of the embodiment

In the embodiment described above, by forming the chamfered portion 12 having a shape that satisfies the conditions described above, it is possible to effectively suppress occurrence of damage during the manufacturing process or handling of the semiconductor substrate 1 formed of a gallium oxide-based single crystal.

### (Example)

Ten types of the semiconductor substrates 1 with the chamfered portions 12 having different shapes (samples A to J) were made, and it was examined whether or not damage occurred on each sample during the step of forming the chamfered portion 12 and during the step of polishing the principal surfaces 10, 11. The samples A to J, each consisting of a 2 inch-diameter (5,08 cm) sample and a 4 inch-diameter (10,16 cm) sample, were made and evaluated.

Each of the samples A to J is a substrate that is formed of β-Ga₂O₃, has the (001)-oriented principal surfaces 10, 11, and is provided with the orientation flats 13a to 13c. In addition, each of the samples A to J is symmetric in the thickness direction and is formed such that the width aₛ₁ and the width aₛ₂ are equal (representatively referred to as the "width aₛ"), the width aₜ₁ and the width aₜ₂ are equal (representatively referred to as the "width at"), and the distance bₛ₁ and the distance bₛ₂ are equal (representatively referred to as the "distance bₛ").

In addition, when forming each of the samples A to J, the inclined surfaces 121, 122 were formed by polishing with a # 600 metal bonded grinding wheel and the end face 123 was formed by polishing with a # 1000 resin bonded grinding wheel.

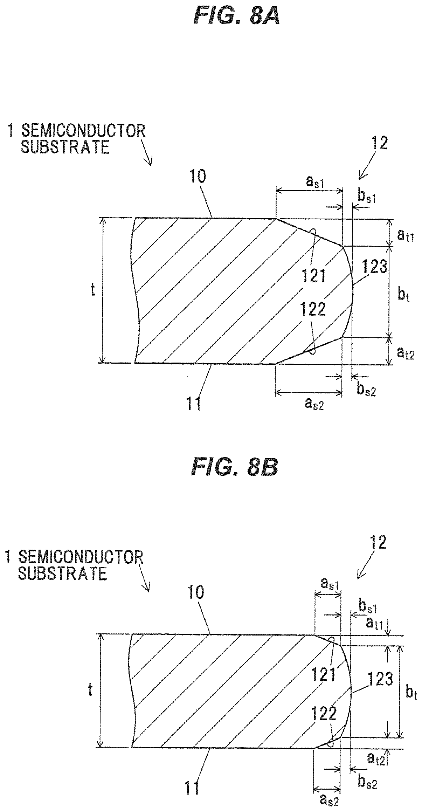

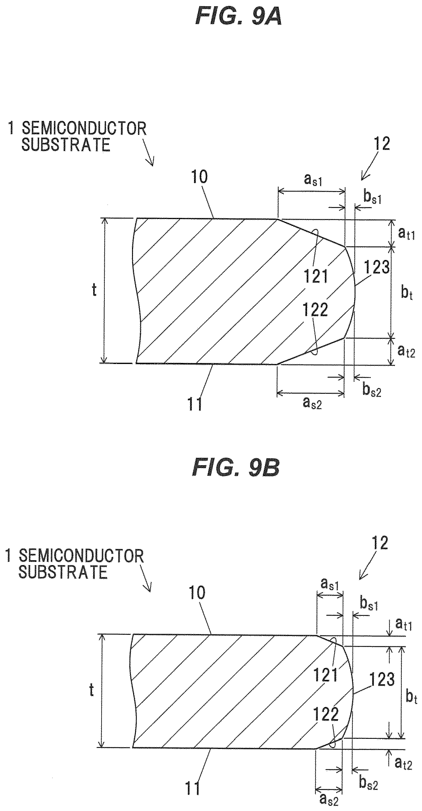

FIGS. 8A and 8B are vertical cross-sectional views showing the chamfered portion 12 and therearound of the sample A respectively before and after polishing the principal surfaces 10, 11 in Step S6. FIGS. 9A and 9B are vertical cross-sectional views showing the chamfered portion 12 and therearound of the sample B respectively before and after polishing the principal surfaces 10, 11 in Step S6.

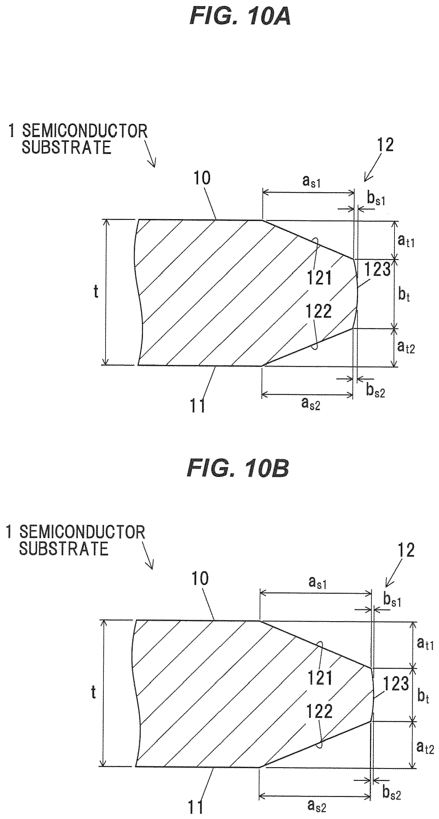

FIGS. 10A and 10B are vertical cross-sectional views respectively showing the chamfered portions 12 and therearound of the samples C and D after polishing the principal surfaces. The samples C and D both have the end face 123 curved along the thickness direction of the semiconductor substrate 1, and have the same thickness t of 0.65 mm and the same inclination angle (aₜ/aₛ) at the inclined surfaces 121, 122, but the distance bt is smaller in the sample D. That is, the chamfered portion 12 of the sample D has a shape obtained by stretching the leading end of the chamfered portion 12 of the sample C so as to be sharper.

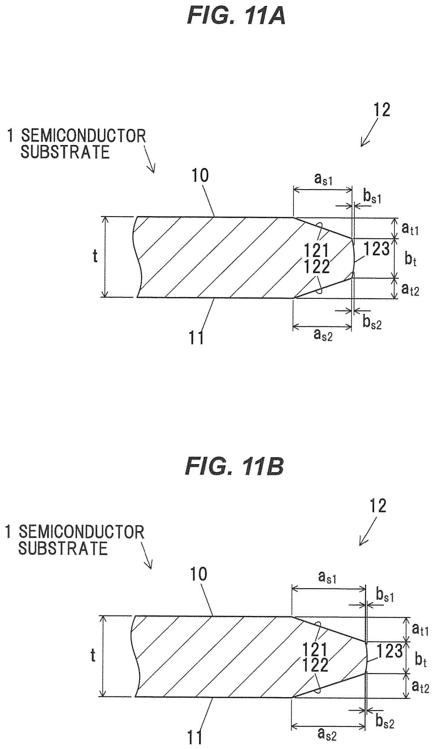

FIGS. 11A and 11B are vertical cross-sectional views respectively showing the chamfered portions 12 and therearound of the samples E and F after polishing the principal surfaces. The samples E and F both have the end face 123 curved along the thickness direction of the semiconductor substrate 1, and have the same thickness t of 0.35 mm and the same inclination angle (aₜ/aₛ) at the inclined surfaces 121, 122, but the distance bt is smaller in the sample F. That is, the chamfered portion 12 of the sample F has a shape obtained by stretching the leading end of the chamfered portion 12 of the sample E so as to be sharper.

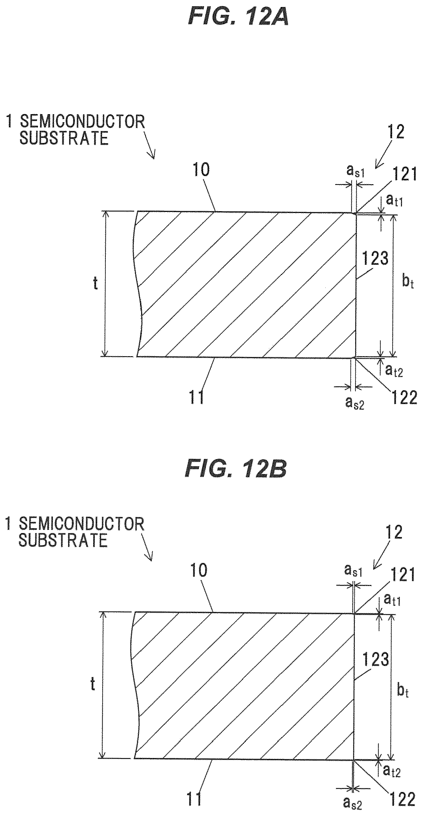

FIGS. 12A and 12B are vertical cross-sectional views respectively showing the chamfered portions 12 and therearound of the samples G and H after polishing the principal surfaces. The samples G and H both have the end face 123 flat along the thickness direction, have the same thickness t of 0.65 mm and both have the relatively small inclined surfaces 121, 122, but the inclined surfaces 121, 122 are smaller in the sample H.

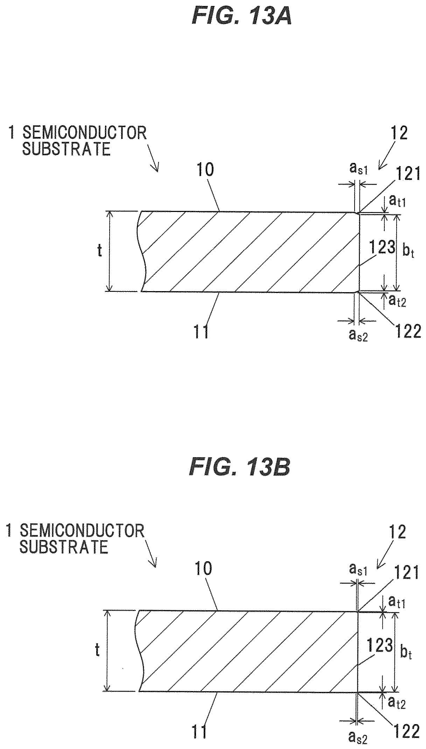

FIGS. 13A and 13B are vertical cross-sectional views respectively showing the chamfered portions 12 and therearound of the samples I and J after polishing the principal surfaces. The samples I and J both have the end face 123 flat along the thickness direction, have the same thickness t of 0.35 mm and both have the relatively small inclined surfaces 121, 122, but the inclined surfaces 121, 122 are smaller in the sample J.

The curvature radius of the end face 123 was 0.6 to 0.7 mm in each of the samples A to F in which the end face 123 was curved along the thickness direction of the semiconductor substrate 1.

Table 1 below shows dimensions of the samples A to J and also shows whether or not damage occurred. In Table 1, "Damage (chamfering)" indicates whether or not damage (cleavage crack, chip or scratches) occurred on the inclined surfaces 121, 122 or the end face 123 during the step of forming the chamfered portion 12 in Step S5. "Damage (principal surface polishing)" indicates whether or not damage (polishing scratches) occurred on the principal surfaces 10, 11 during the step of polishing the principal surfaces 10, 11 in Step S6. Then, "Sample A (before polishing)" and "Sample B (before polishing)" means respectively the sample A and the sample B before polishing the principal surfaces 10, 11 in Step S6. Regarding each of the samples A to J, the result (whether or not damage occurred) from the 2 inch-diameter (5,08 cm) sample and the 4 inch-diameter (10,16 cm) sample was the same.

**Table 1**

| | aₛ [mm] | aₜ [mm] | bₛ [mm] | bₜ [mm] | t [mm] | bₜ/t [%] | Damage (chamfering) | Damage (principal surface polishing) |
|---|---|---|---|---|---|---|---|---|
| Sample A (before polishing) | 0.46 | 0.15 | 0.065 | 0.55 | 0.85 | 65 | None | - |
| Sample A | 0.22 | 0.05 | 0.065 | 0.55 | 0.65 | 85 | None | None |
| Sample B (before polishing) | 0.30 | 0.10 | 0.033 | 0.30 | 0.50 | 60 | None | - |
| Sample B | 0.12 | 0.025 | 0.033 | 0.30 | 0.35 | 86 | None | None |
| Sample C | 0.45 | 0.16 | 0.020 | 0.33 | 0.65 | 50 | None | None |
| Sample D | 0.52 | 0.195 | 0.018 | 0.26 | 0.65 | 40 | Damaged | None |
| Sample E | 0.27 | 0.085 | 0.010 | 0.18 | 0.35 | 50 | None | None |
| Sample F | 0.32 | 0.105 | 0.008 | 0.14 | 0.35 | 40 | Damaged | None |
| Sample G | 0.025 | 0.010 | - | 0.63 | 0.65 | 97 | None | None |
| Sample H | 0.00804 | 0.00325 | - | 0.644 | 0.65 | 99 | None | Damaged |
| Sample I | 0.025 | 0.010 | - | 0.33 | 0.35 | 94 | None | None |
| Sample J | 0.0087 | 0.0035 | - | 0.343 | 0.35 | 98 | None | Damaged |

As shown in Table 1, in the samples D and F, damage was observed on the chamfered portion 12 immediately after chamfering. It is considered that cleavage crack occurred since the width bt was less than 50% of the thickness t and the leading end of the chamfered portion 12 was sharp.

Also as shown in Table 1, in the samples H and J, damage was observed on the polished principal surface 10, 11. It is considered that damage occurred in the vicinity of the edges of the polished principal surface 10, 11 and polishing scratches were caused by broken pieces since the width bt was more than 97% of the thickness t and the inclined surfaces 121, 122 were too small.

On the other hand, as shown in Table 1, in the samples A to C, E, G and I in which the width bt was within the range of not less than 50% and not more than 97% of the thickness t, damage was not observed on the chamfered portion 12 and the principal surface 10, 11.

Although the embodiment and Example of the invention have been described, the invention is not limited to the embodiment and Example, and the various kinds of modifications can be implemented without departing from the gist of the invention.

In addition, the embodiment and Example described above do not limit the invention according to claims. Further, please note that all combinations of the features described in the embodiment and Example are not necessary to solve the problem of the invention.

### Reference Signs List

1 SEMICONDUCTOR SUBSTRATE
10, 11 PRINCIPAL SURFACE
12 CHAMFERED PORTION
121, 122 INCLINED SURFACE
123 END FACE
13a, 13b, 13c ORIENTATION FLAT
20 BULK SINGLE CRYSTAL

## Claims

1. A semiconductor substrate (1), comprising:
a gallium oxide-based semiconductor single crystal; and
a chamfered portion (12) at an outer periphery portion;
wherein the chamfered portion (12) comprises a first inclined surface (121) located on the outer side of a first principal surface (10) of the semiconductor substrate (1) and being linear at an edge in a vertical cross section of the semiconductor substrate (1), a second inclined surface (122) located on the outer side of a second principal surface (11) on the opposite side to the first principal surface (10) of the semiconductor substrate (1) and being linear at an edge in the vertical cross section of the semiconductor substrate (1), and an end face (123) located between the first inclined surface (121) and the second inclined surface (122) at a leading end of the chamfered portion (12), and
wherein a width of the end face (123) in a thickness direction of the semiconductor substrate (1) is within the range of not less than 50% and not more than 97% of a thickness of the semiconductor substrate (1).

2. The semiconductor substrate (1) according to claim 1, wherein widths of the first inclined surface (121) and the second inclined surface (122) in an in-plane direction of the semiconductor substrate (1) are within the range of not less than 0.025 mm and not more than 0.9 mm.

3. The semiconductor substrate (1) according to claim 1 or 2, wherein plane orientations of the first principal surface (10) and the second principal surface (11) are (001) or (100).

4. The semiconductor substrate (1) according to any one of claims 1 to 3, wherein the plane orientations of the first principal surface (10) and the second principal surface (11) are (001), and an orientation flat (13a) is formed along a <010> direction.

5. The semiconductor substrate (1) according to any one of claims 1 to 4, wherein the semiconductor substrate (1) is symmetric in the thickness direction thereof.

6. The semiconductor substrate (1) according to any one of claims 1 to 5, wherein the end face (123) is curved along the thickness direction of the semiconductor substrate (1) so as to bulge outward.

7. The semiconductor substrate (1) according to any one of claims 1 to 5, wherein the end face (123) is flat along the thickness direction of the semiconductor substrate (1).

8. The semiconductor substrate (1) according to claim 7, wherein a curvature radius of the end face (123) in the vertical cross section of the semiconductor substrate (1) is not less than 340 µm.

9. A method for manufacturing a semiconductor substrate (1) comprising a gallium oxide-based semiconductor single crystal, the method comprising:
forming a chamfered portion (12) by chamfering an outer periphery portion of the semiconductor substrate (1); and
after forming the chamfered portion (12), polishing a first principal surface (10) of the semiconductor substrate (1) and a second principal surface (111) on the opposite side to the first principal surface (10),
wherein the chamfered portion (12) comprises a first inclined surface (121) located on the outer side of the first principal surface (10) and being linear at an edge in a vertical cross section of the semiconductor substrate (1), a second inclined surface (122) located on the outer side of the second principal surface (11) and being linear at an edge in the vertical cross section of the semiconductor substrate (1), and an end face (123) located between the first inclined surface (121) and the second inclined surface (122) at a leading end of the chamfered portion (12), and
wherein a width of the end face (123) in a thickness direction of the semiconductor substrate (1) after the polishing is within the range of not less than 50% and not more than 97% of a thickness of the semiconductor substrate (1) after the polishing.

10. The method according to claim 9, wherein, in the forming of the chamfered portion (12), the end face (123) is formed after forming the first inclined surface (121) and the second inclined surface (122).

11. The method according to claim 9 or 10, wherein, in the forming of the chamfered portion (12), the end face (123) is formed using a grinding wheel that is softer than a grinding wheel used for forming the first inclined surface (121) and the second inclined surface (122).

12. The method according to claim 11, wherein, in the forming of the chamfered portion (12), the end face (123) is formed using a resin bonded grinding wheel.

13. The method according to any one of claims 9 to 12, wherein widths of the first inclined surface (121) and the second inclined surface (122) in an in-plane direction of the semiconductor substrate (1) after the polishing are within the range of not less than 0.025 mm and not more than 0.9 mm.

14. The method according to any one of claims 9 to 13, wherein plane orientations of the first principal surface (10) and the second principal surface (11) are (001) or (100).

## Patentansprüche

1. Ein Halbleitersubstrat (1), umfassend:
einen Galliumoxid-basierten Halbleiter-Einkristall; und
einen abgeschrägten Abschnitt (12) an einem äußeren Randabschnitt;
wobei der abgeschrägte Abschnitt (12) eine erste geneigte Fläche (121), die sich an der Außenseite einer ersten Hauptfläche (10) des Halbleitersubstrats (1) befindet und an einer Kante in einem vertikalen Querschnitt des Halbleitersubstrats (1) linear ist, eine zweite geneigte Fläche (122), die sich an der Außenseite einer zweiten Hauptfläche (11) auf der der ersten Hauptoberfläche (10) gegenüberliegenden Seite des Halbleitersubstrats (1) befindet und an einer Kante im vertikalen Querschnitt des Halbleitersubstrats (1) linear ist, und eine Endfläche (123), die sich zwischen der ersten geneigten Oberfläche (121) und der zweiten geneigten Oberfläche (122) an einem vorderen Ende des abgeschrägten Abschnitts (12) befindet, umfasst und
wobei eine Breite der Endfläche (123) in einer Dickenrichtung des Halbleitersubstrats (1) im Bereich von nicht weniger als 50 % und nicht mehr als 97 % einer Dicke des Halbleitersubstrats (1) liegt.

2. Das Halbleitersubstrat (1) gemäß Anspruch 1, wobei die Breiten der ersten geneigten Fläche (121) und der zweiten geneigten Fläche (122) in einer Richtung in der Ebene des Halbleitersubstrats (1) im Bereich von nicht weniger als 0,025 mm und nicht mehr als 0,9 mm liegen.

3. Das Halbleitersubstrat (1) gemäß Anspruch 1 oder 2, wobei die Ebenenorientierungen der ersten Hauptoberfläche (10) und der zweiten Hauptoberfläche (11) (001) oder (100) sind.

4. Das Halbleitersubstrat (1) gemäß einem der Ansprüche 1 bis 3, wobei die Ebenenorientierungen der ersten Hauptoberfläche (10) und der zweiten Hauptoberfläche (11) (001) sind und eine Orientierungsfläche (13a) entlang einer <010>-Richtung ausgebildet ist.

5. Halbleitersubstrat (1) nach einem der Ansprüche 1 bis 4, wobei das Halbleitersubstrat (1) in seiner Dickenrichtung symmetrisch ist.

6. Halbleitersubstrat (1) nach einem der Ansprüche 1 bis 5, wobei die Endfläche (123) entlang der Dickenrichtung des Halbleitersubstrats (1) gekrümmt ist, so dass sie sich nach außen wölbt.

7. Halbleitersubstrat (1) gemäß einem der Ansprüche 1 bis 5, wobei die Endfläche (123) entlang der Dickenrichtung des Halbleitersubstrats (1) flach ist.

8. Halbleitersubstrat (1) gemäß Anspruch 7, wobei ein Krümmungsradius der Endfläche (123) im vertikalen Querschnitt des Halbleitersubstrats (1) nicht weniger als 340 µm beträgt.

9. Verfahren zur Herstellung eines Halbleitersubstrats (1), das einen Galliumoxid-basierten Halbleiter-Einkristall umfasst, wobei das Verfahren umfasst:
Ausbilden eines abgeschrägten Abschnitts (12) durch Abschrägen eines äußeren Randabschnitts des Halbleitersubstrats (1); und
nach der Bildung des abgeschrägten Abschnitts (12) Polieren einer ersten Hauptoberfläche (10) des Halbleitersubstrats (1) und einer zweiten Hauptoberfläche (111) auf der der ersten Hauptoberfläche (10) gegenüberliegenden Seite,
wobei der abgeschrägte Abschnitt (12) eine erste geneigte Fläche (121), die sich an der Außenseite der ersten Hauptfläche (10) befindet und an einer Kante in einem vertikalen Querschnitt des Halbleitersubstrats (1) linear ist, eine zweite geneigte Fläche (122), die sich an der Außenseite der zweiten Hauptoberfläche (11) befindet und an einer Kante im vertikalen Querschnitt des Halbleitersubstrats (1) linear ist, und eine Endfläche (123), die sich zwischen der ersten geneigten Fläche (121) und der zweiten geneigten Fläche (122) an einem vorderen Ende des abgeschrägten Abschnitts (12) befindet, aufweist und
wobei eine Breite der Endfläche (123) in einer Dickenrichtung des Halbleitersubstrats (1) nach dem Polieren innerhalb des Bereichs von nicht weniger als 50 % und nicht mehr als 97 % einer Dicke des Halbleitersubstrats (1) nach dem Polieren liegt.

10. Verfahren nach Anspruch 9, wobei bei der Bildung des abgeschrägten Abschnitts (12) die Endfläche (123) nach der Bildung der ersten geneigten Fläche (121) und der zweiten geneigten Fläche (122) gebildet wird.

11. Verfahren nach Anspruch 9 oder 10, wobei beim Formen des abgeschrägten Abschnitts (12) die Endfläche (123) unter Verwendung einer Schleifscheibe geformt wird, die weicher ist als eine Schleifscheibe, die zum Formen der ersten geneigten Fläche (121) und der zweiten geneigten Fläche (122) verwendet wird.

12. Verfahren nach Anspruch 11, wobei bei der Formung des abgeschrägten Abschnitts (12) die Endfläche (123) unter Verwendung einer kunstharzgebundenen Schleifscheibe geformt wird.

13. Verfahren nach einem der Ansprüche 9 bis 12, wobei die Breiten der ersten geneigten Fläche (121) und der zweiten geneigten Fläche (122) in einer Richtung in der Ebene des Halbleitersubstrats (1) nach dem Polieren im Bereich von nicht weniger als 0,025 mm und nicht mehr als 0,9 mm liegen.

14. Verfahren nach einem der Ansprüche 9 bis 13, wobei die Ebenenorientierungen der ersten Hauptoberfläche (10) und der zweiten Hauptoberfläche (11) (001) oder (100) sind.

## Revendications

1. Un substrat semi-conducteur (1), comprenant :
un monocristal semi-conducteur à base d'oxyde de gallium ; et
une partie chanfreinée (12) au niveau d'une partie périphérique extérieure ;
la partie chanfreinée (12) comprend une première surface inclinée (121) située sur le côté extérieur d'une première surface principale (10) du substrat semi-conducteur (1) et étant linéaire au niveau d'un bord dans une section transversale verticale du substrat semi-conducteur (1), une deuxième surface inclinée (122) située sur le côté extérieur d'une deuxième surface principale (11) sur le côté opposé à la première surface principale (10) du substrat semi-conducteur (1) et étant linéaire au niveau d'un bord dans la section transversale verticale du substrat semi-conducteur (1), et une face d'extrémité (123) située entre la première surface inclinée (121) et la deuxième surface inclinée (122) à une extrémité avant de la partie chanfreinée (12), et
une largeur de la face d'extrémité (123) dans une direction d'épaisseur du substrat semi-conducteur (1) est dans la plage d'au moins 50 % et d'au plus 97 % d'une épaisseur du substrat semi-conducteur (1).

2. Le substrat semi-conducteur (1) selon la revendication 1, dans lequel les largeurs de la première surface inclinée (121) et de la deuxième surface inclinée (122) dans une direction dans le plan du substrat semi-conducteur (1) sont comprises dans la plage d'au moins 0,025 mm et d'au plus 0,9 mm.

3. Le substrat semi-conducteur (1) selon la revendication 1 ou la revendication 2, dans lequel les orientations planes de la première surface principale (10) et de la deuxième surface principale (11) sont (001) ou (100).

4. Le substrat semi-conducteur (1) selon l'une quelconque des revendications 1 à 3, dans lequel les orientations planes de la première surface principale (10) et de la deuxième surface principale (11) sont (001), et un méplat d'orientation (13a) est formé le long d'une direction <010>.

5. Le substrat semi-conducteur (1) selon l'une quelconque des revendications 1 à 4, dans lequel le substrat semi-conducteur (1) est symétrique dans le sens de son épaisseur.

6. Le substrat semi-conducteur (1) selon l'une quelconque des revendications 1 à 5, dans lequel la face d'extrémité (123) est courbée dans le sens de l'épaisseur du substrat semi-conducteur (1) de manière à se renfler vers l'extérieur.

7. Le substrat semi-conducteur (1) selon l'une quelconque des revendications 1 à 5, dans lequel la face d'extrémité (123) est plate dans le sens de l'épaisseur du substrat semi-conducteur (1).

8. Le substrat semi-conducteur (1) selon la revendication 7, dans lequel un rayon de courbure de la face d'extrémité (123) dans la section transversale verticale du substrat semi-conducteur (1) n'est pas inférieur à 340 µm.

9. Un procédé de fabrication d'un substrat semi-conducteur (1) comprenant un monocristal semi-conducteur à base d'oxyde de gallium, le procédé comprenant :
le fait de former une partie chanfreinée (12) par chanfreinage d'une partie périphérique extérieure du substrat semi-conducteur (1) ; et
après avoir formé la partie chanfreinée (12), le fait de polir une première surface principale (10) du substrat semi-conducteur (1) et une deuxième surface principale (111) sur le côté opposé à la première surface principale (10),
la partie chanfreinée (12) comprenant une première surface inclinée (121) située sur le côté extérieur de la première surface principale (10) et étant linéaire au niveau d'un bord dans une section transversale verticale du substrat semi-conducteur (1), une deuxième surface inclinée (122) étant située sur le côté extérieur de la deuxième surface principale (11) et étant linéaire au niveau d'un bord dans la section transversale verticale du substrat semi-conducteur (1), et une face d'extrémité (123) étant située entre la première surface inclinée (121) et la deuxième surface inclinée (122) à une extrémité avant de la partie chanfreinée (12), et
une largeur de la face d'extrémité (123) dans une direction d'épaisseur du substrat semi-conducteur (1) après le polissage étant dans une gamme allant d'au moins 50 % à au plus 97 % d'une épaisseur du substrat semi-conducteur (1) après le polissage.

10. Le procédé selon la revendication 9,
dans lequel, lors de la formation de la partie chanfreinée (12),
la face d'extrémité (123) est formée après la formation de la première surface inclinée (121) et de la deuxième surface inclinée (122).

11. Le procédé selon la revendication 9 ou la revendication 10,
dans lequel, lors de la formation de la partie chanfreinée (12), la face d'extrémité (123) est formée en utilisant une meule qui est plus molle qu'une meule utilisée pour former la première surface inclinée (121) et la deuxième surface inclinée (122).

12. Le procédé selon la revendication 11 ;
dans lequel, lors de la formation de la partie chanfreinée (12), la face d'extrémité (123) est formée en utilisant une meule liée par de la résine.

13. Le procédé selon l'une quelconque des revendications 9 à 12 ;
dans lequel les largeurs de la première surface inclinée (121) et de la deuxième surface inclinée (122) dans une direction dans le plan du substrat semi-conducteur (1) après le polissage sont comprises dans la plage d'au moins 0,025 mm et d'au plus 0,9 mm.

14. Le procédé selon l'une quelconque des revendications 9 à 13,
dans lequel les orientations planes de la première surface principale (10) et de la deuxième surface principale (11) sont (001) ou (100).
